(19) **Europäisches Patentamt**
**European Patent Office**
**Office européen des brevets**

(11) **EP 3 867 653 B1**

(12) **EUROPÄISCHE PATENTSCHRIFT**

(45) Veröffentlichungstag und Bekanntmachung des Hinweises auf die Patenterteilung:
**01.11.2023 Patentblatt 2023/44**

(21) Anmeldenummer: **19779761.6**

(22) Anmeldetag: **16.09.2019**

(51) Internationale Patentklassifikation (IPC):
**G01R 22/06** (2006.01)   **G01R 31/40** (2020.01)
**G01R 22/10** (2006.01)   **G01R 21/133** (2006.01)

(52) Gemeinsame Patentklassifikation (CPC):
**G01R 22/061; G01R 21/133; G01R 22/068;**
**G01R 22/10; G01R 31/40;** Y02T 10/70;
Y02T 10/7072; Y02T 90/12; Y02T 90/16

(86) Internationale Anmeldenummer:
**PCT/EP2019/074671**

(87) Internationale Veröffentlichungsnummer:
**WO 2020/078633 (23.04.2020 Gazette 2020/17)**

(54) **LADESYSTEM MIT EINEM STROMZÄHLER UND EINEM LADEKABEL**

CHARGING SYSTEM WITH AN ELECTRIC METER AND A CHARGING CABLE

SYSTÈME DE CHARGE AVEC UN COMPTEUR ÉLECTRIQUE ET UN CÂBLE DE CHARGE

(84) Benannte Vertragsstaaten:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorität: **16.10.2018 DE 102018125598**

(43) Veröffentlichungstag der Anmeldung:
**25.08.2021 Patentblatt 2021/34**

(73) Patentinhaber: **Isabellenhütte Heusler GmbH &**
**Co. KG**
**35683 Dillenburg (DE)**

(72) Erfinder:
- **LEPPER, Andreas**
  **35644 Hohenahr (DE)**
- **POLLMANN, Michael**
  **35689 Dillenburg (DE)**

(74) Vertreter: **v. Bezold & Partner Patentanwälte -**
**PartG mbB**
**Ridlerstraße 57**
**80339 München (DE)**

(56) Entgegenhaltungen:

| | |
|---|---|
| EP-A1- 0 787 994 | EP-B1- 0 787 994 |
| WO-A1-2018/186529 | CN-A- 104 682 520 |
| CN-A- 105 699 816 | CN-A- 106 569 145 |
| CN-U- 205 185 893 | FR-A1- 2 947 055 |

| | |
|---|---|
| FR-A1- 2 987 449 | JP-A- 2001 028 844 |
| KR-A- 20160 051 363 | KR-A- 20160 096 350 |
| US-A1- 2010 174 667 | US-A1- 2011 285 350 |
| US-A1- 2015 346 288 | US-B1- 9 020 771 |

- WINKLER T ET AL: "Electric vehicle charging stations in Magdeburg", VEHICLE POWER AND PROPULSION CONFERENCE, 2009. VPPC '09. IEEE, IEEE, PISCATAWAY, NJ, USA, 7. September 2009 (2009-09-07), Seiten 60-65, XP031637887, ISBN: 978-1-4244-2600-3
- STOYCHEV IVAN ET AL: "A measurement system for electric car charging stations utilising a FPGA board for flexibility in configuration", 2016 IEEE INTERNATIONAL SYMPOSIUM ON CIRCUITS AND SYSTEMS (ISCAS), IEEE, 22. Mai 2016 (2016-05-22), Seiten 630-633, XP032941628, DOI: 10.1109/ISCAS.2016.7527319 [gefunden am 2016-07-29]
- Schneider Electric: "EVlink -QC@BULLET@BULLET@BULLET Electric Vehicle Quick Charging Station Installation Manual", , 30 September 2011 (2011-09-30), XP055200125, Internet Retrieved from the Internet: URL:http://download.schneider-electric.com /files?L=en&p=60852&p_docId=&p_docId=&p_Re ference=S1B54439&p_EnDocType=User guide&p_File_Id=840308956&p_File_Name=S1B 5 4439.pdf [retrieved on 2015-07-03]

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- STOYCHEV IVAN ET AL: "Sensor data fusion with MPSoCSim in the context of electric vehicle charging stations", 2016 IEEE NORDIC CIRCUITS AND SYSTEMS CONFERENCE (NORCAS), IEEE, 1 November 2016 (2016-11-01), pages 1-6, XP033034361, DOI: 10.1109/NORCHIP.2016.7792878 [retrieved on 2016-12-21]

**Beschreibung**

Die Erfindung betrifft ein Ladesystem mit einem Ladekabel und einem Stromzähler zur elektrischen Verbrauchsmessung an einem elektrischen Verbraucher (z. B. Elektroauto).

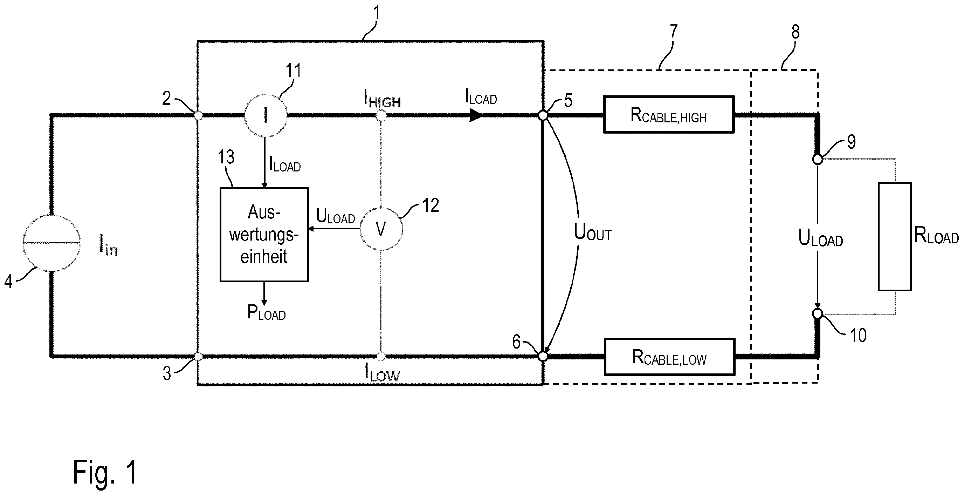

Aus dem Stand der Technik sind Stromzähler bekannt, die beispielsweise bei einem Ladevorgang eines Elektroautos eingesetzt werden, um die bei einem Ladevorgang entnommene elektrische Leistung zu messen, was für eine Verbrauchsabrechnung erforderlich ist. Figur 1 zeigt eine schematische Darstellung eines solchen bekannten Stromzählers 1, der eingangsseitig über einen High-Side-Stromanschluss 2 und einen Low-Side-Stromanschluss 3 mit einer Ladequelle 4 verbunden ist, die hier nur schematisch dargestellt ist. Ausgangsseitig weist der Stromzähler ebenfalls einen High-Side-Stromanschluss 5 und einen Low-Side-Stromanschluss 6 auf, wobei der High-Side-Stromanschluss 5 und der Low-Side-Stromanschluss 6 über ein Ladekabel 7 mit einem Stecker 8 mit einem elektrischen Verbraucher $R_{LOAD}$ verbunden ist. Der Stecker 8 weist hierbei zwei Anschlüsse 9,10 auf, die einen Übergabepunkt zu dem Verbraucher $R_{LOAD}$ definieren. In dem Ladekabel 7 verläuft an der High-Side eine Ladeleitung $R_{CABLE,HIGH}$ und an der Low-Side eine Ladeleitung $R_{CABLE,LOW}$. Bei einem Ladevorgang fließt ein Ladestrom $I_{LOAD}$ durch das Ladekabel 7 zu dem Verbraucher $R_{LOAD}$, um beispielsweise eine wieder aufladbare Batterie in einem Elektroauto aufzuladen. Der Ladestrom $I_{LOAD}$ wird in dem Stromzähler 1 durch eine Strommesseinrichtung 11 gemessen, wobei die Strommesseinrichtung 11 den Ladestrom $I_{LOAD}$ beispielsweise mittels eines niederohmigen Strommesswiderstands ("Shunt") messen kann. Darüber hinaus enthält der Stromzähler 1 eine Spannungsmesseinrichtung 12, die eine Ausgangsspannung $U_{OUT}$ zwischen High-Side und Low-Side innerhalb des Stromzählers 1 misst. Eine Auswertungseinheit 13 berechnet dann aus dem gemessenen Ladestrom $I_{LOAD}$ und der gemessenen Ausgangsspannung $U_{OUT}$ die Ladeleistung $P_{LOAD}$, die für eine Verbrauchsabrechnung herangezogen werden kann.

Problematisch an diesem bekannten Messprinzip ist die Tatsache, dass die Leitungsverluste in dem Ladekabel 7 nicht berücksichtigt werden, so dass die tatsächliche Ladeleistung an dem durch die beiden Anschlüsse 9, 10 des Steckers 8 gebildeten Übergabepunkt kleiner ist als die von der Auswertungseinheit 13 berechnete Ladeleistung $P_{LOAD}$.

Ein weiteres Problem dieses bekannten Messprinzips besteht darin, dass die Qualität der elektrischen Kontaktierung an dem High-Side-Stromanschluss 5 und an dem Low-Side-Stromanschluss 6 nicht überprüft werden kann.

Ferner besteht auch die Möglichkeit, dass sich der Widerstand der beiden Ladeleitungen $R_{CABLE,HIGH}$, $R_{CABLE,LOW}$ während des Betriebs im Laufe der Zeit verschlechtert, was ebenfalls nicht erkannt werden kann.

Zum Stand der Technik ist auch hinzuweisen auf US 2011/285350 A1, FR 2 947 055 A1, KR 2016 0096350 A, FR 2 987 449 A1, US 2015/346288 A1, EP 0 787 994 A1, CN 104 682 520 A, KR 2016 0051363 A, CN 205 185 893 U, CN 105 699 816 A, JP 2001 028844 A, WINKLER T. et al.: "Electric vehicle charging stations in Magdeburg" (Vehicle Power and Propulsion Conference, 2009, VPPC '09, Seiten 60-65, XP031637887) und US 2010/174667 A1.

Der Erfindung liegt deshalb die Aufgabe zugrunde, ein entsprechend verbessertes Ladesystem mit einem Stromzähler und einem Ladekabel zu schaffen.

Diese Aufgabe wird durch ein erfindungsgemäßes Ladesystem gemäß Anspruch 1.

Die Erfindung beruht zunächst auf der technisch-physikalischen Erkenntnis, dass die Leitungswiderstände in dem Ladekabel und die Kontaktwiderstände am Ausgang des Stromzählers im Betrieb problematisch sind, wie vorstehend bereits erläutert wurde. Die Erfindung umfasst deshalb die allgemeine technische Lehre, dass die Spannungsmesseinrichtung in dem Stromzähler die elektrische Spannung direkt an dem Übergabepunkt des Ladekabels misst, d.h. in der Regel in dem lösbaren Stecker, um auch die Leitungsverluste berücksichtigen zu können.

Zum einen ermöglicht dies eine exakte Verbrauchsberechnung, da die Leitungsverluste in dem Ladekabel dem Kunden nicht in Rechnung gestellt werden.

Zum anderen ermöglicht die Spannungsmessung an dem Übergabepunkt aber auch eine Beurteilung der Qualität der elektrischen Kontaktierung zwischen Stromzähler und Ladekabel sowie eine Erkennung einer zeitlichen Änderung der Leitungswiderstände in dem Ladekabel.

Der Stromzähler weist bei dem erfindungsgemäßen Ladesystem zunächst in Übereinstimmung mit dem eingangs beschriebenen bekannten Stromzähler eine Strommesseinrichtung auf, um den Ladestrom zu messen, der über ein Ladekabel zu einem Übergabepunkt für den Verbraucher fließt, wobei sich der Übergabepunkt vorzugsweise in einem Stecker des Ladekabels befindet.

In einem bevorzugten Ausführungsbeispiel der Erfindung erfolgt die Strommessung durch die Strommesseinrichtung mittels eines niederohmigen Strommesswiderstands ("Shunt") gemäß der bekannten Vierleitertechnik. Dabei wird der Ladestrom durch den niederohmigen Strommesswiderstand geleitet und die Spannung über dem Strommesswiderstand gemessen, die entsprechend dem ohmschen Gesetz ein Maß für den Ladestrom bildet.

Die Erfindung ist jedoch hinsichtlich des Messprinzips der Strommesseinrichtung nicht auf eine Shunt-basierte Strommessung beschränkt. Vielmehr kann die Strommesseinrichtung grundsätzlich auch andere Messprinzipien zur Strommessung anwenden.

Darüber hinaus umfasst der Stromzähler in Übereinstimmung mit dem Stand der Technik eine Spannungsmesseinrichtung zur Spannungsmessung. Der Stromzähler unterscheidet sich nun von dem eingangs beschriebenen bekannten Stromzähler dadurch, dass die Spannungsmesseinrichtung und die Spannung nicht oder nicht nur innerhalb des Stromzählers misst, sondern direkt an dem Übergabepunkt zu dem Verbraucher, so dass Leitungsverluste in dem Ladekabel berücksichtigt werden können. Diese Spannungsmessung direkt an dem Übergabepunkt erfolgt vorzugsweise durch Messleitungen, die in dem Ladekabel von dem Übergabepunkt ausgehen und zu dem Stromzähler geführt sind, weshalb die Erfindung auch ein entsprechend angepasstes Ladekabel umfasst, wie noch detailliert beschrieben wird.

In dem bevorzugten Ausführungsbeispiel der Erfindung weist der Stromzähler eingangsseitig zwei Stromanschlüsse auf, um den Stromzähler mit einer Ladequelle zu verbinden. Darüber hinaus weist der Stromzähler vorzugsweise auch ausgangsseitig zwei Stromanschlüsse auf, um den Stromzähler über ein Ladekabel mit dem Verbraucher verbinden zu können. Der Ladestrom wird hierbei also von der Ladequelle erzeugt und fließt durch den Stromzähler zu dem Verbraucher und wieder zurück.

Darüber hinaus weist der Stromzähler vorzugsweise einen ersten Spannungsmesseingang und einen zweiten Spannungsmesseingang auf, um die Spannung direkt an dem Übergabepunkt zu dem Verbraucher zu messen. Ferner weist die Spannungsmesseinrichtung vorzugsweise einen dritten Spannungsmesseingang auf, um eine Spannung an dem eingangsseitigen zweiten Stromanschluss gegenüber einem Referenzpotential zu messen. Das Referenzpotential ist hierbei vorzugsweise für alle Spannungsmesseingänge das gleiche und wird vorzugsweise durch den ausgangsseitigen ersten Stromanschluss gebildet.

Beispielsweise können die Spannungsmesseingänge jeweils über einen Spannungsteiler mit dem Referenzpotential verbunden werden, wobei derartige Spannungsteiler zur Spannungsmessung an sich aus dem Stand der Technik bekannt sind und deshalb nicht näher beschrieben werden müssen.

Darüber hinaus enthält der Stromzähler vorzugsweise eine Auswertungseinheit zur Ermittlung der in dem Ladekabel auftretenden Leitungsverluste in Abhängigkeit von der Spannungsmessung, die durch die Spannungsmesseinrichtung erfolgt. Alternativ oder zusätzlich kann die Auswertungseinheit auch andere Betriebsgrößen berechnen, wie beispielsweise folgende Betriebsgrößen:

- Die an dem Übergabepunkt abfallende Ladespannung,
- den Spannungsabfall über der ersten Ladeleitung des Ladekabels,
- den Spannungsabfall über der zweiten Ladeleitung des Ladekabels,
- die Leitungsverluste in dem Ladekabel,
- den Leitungswiderstand der ersten Ladeleitung des Ladekabels,
- den Leitungswiderstand der zweiten Ladeleitung des Ladekabels.

Darüber hinaus besteht im Rahmen der Erfindung die Möglichkeit einer Plausibilisierung der Messwerte für die Ladespannung. Hierbei kann die Spannungsmesseinrichtung die Ladespannung direkt an dem Übergabepunkt zu dem Verbraucher messen. Die Auswertungseinheit kann dann einen zweiten Messwert für die Ladespannung berechnen, der die Leitungsverluste in dem Ladekabel nicht berücksichtigt und beispielsweise aus der dritten Spannung und dem Referenzpotential berechnet wird. Die Auswertungseinheit kann dann die beiden Messwerte der Ladespannung miteinander vergleichen und in Abhängigkeit von dem Vergleich ein Fehlersignal ausgeben, beispielsweise zur Signalisierung eines Leitungsbruchs in dem Ladekabel oder einer schlechten Kontaktqualität zwischen dem Stromzähler und dem Ladekabel.

Eine ähnliche Auswertung kann auch hinsichtlich der Leitungswiderstände in dem Ladekabel erfolgen. So ermöglichen die vorstehend beschriebenen verschiedenen Spannungsmessungen auch die Berechnungen des Leitungswiderstands des Ladekabels. Die Auswertungseinheit kann dann überprüfen, ob der Leitungswiderstand des Ladekabels innerhalb eines vorgegebenen Toleranzfeldes liegt und ein Fehlersignal ausgeben, wenn der berechnete Leitungswiderstand außerhalb des Toleranzfeldes liegt. Darüber hinaus lässt sich auf diese Weise auch die Qualität der Kontaktierung zwischen dem Stromzähler und dem Übergabepunkt überprüfen, d.h. die Auswertungseinheit kann ein Kontrollsignal ausgeben, das anzeigt, ob das Ladekabel korrekt an den Stromzähler angeschlossen ist.

In dem bevorzugten Ausführungsbeispiel der Erfindung ist der eingangsseitige zweite Stromanschluss leitend mit dem ausgangsseitigen zweiten Stromanschluss verbunden oder in einem einzigen Stromanschluss zusammengefasst. Der eingangsseitige erste Stromanschluss ist dagegen vorzugsweise über den niederohmigen Strommesswiderstand bzw. allgemein über die Strommesseinrichtung mit dem ausgangsseitigen ersten Stromanschluss verbunden.

Grundsätzlich ist das erfindungsgemäße Prinzip sowohl zur Gleichstrommessung als auch zur Wechselstrommessung geeignet. In dem bevorzugten Ausführungsbeispiel der Erfindung ist der Stromzähler dagegen zur Gleichstrommessung geeignet und entsprechend ausgebildet. Der eingangsseitige erste Stromanschluss ist dann ein High-Side-Stromanschluss, der den Ladestrom an der High-Side von der Ladequelle aufnimmt. Der eingangsseitige zweite Stromanschluss ist dann ein Low-Side-Stromanschluss, der den Ladestrom an der Low-Side zu der Ladequelle zurückführt. An der Ausgangsseite des Stromzählers ist der ausgangsseitige erste Stromanschluss dann ein High-Side-Stromanschluss, der den Ladestrom an der High-Side zu dem Verbraucher ausgibt. Der ausgangsseitige zweite Stromanschluss ist dann ein Low-Side-Stromanschluss, der den Ladestrom an der Low-Side von dem Verbraucher aufnimmt. Der erste Spannungsmesseingang ist dann ein High-Side-Spannungsmesseingang, um das elektrische Potential an dem Übergabepunkt zu dem Verbraucher an der High-Side zu messen. Der zweite Spannungsmesseingang ist dagegen bei einer Gleichstrommessung ein Low-Side-Spannungsmesseingang, der das elektrische Potential an dem Übergabepunkt zu dem Verbraucher an der Low-Side misst. Das Ladekabel weist dann eine High-Side-Leitung und eine Low-Side-Leitung auf.

Es wurde bereits vorstehend kurz erwähnt, dass das erfindungsgemäße Ladesystem auch ein entsprechend angepasstes Ladekabel umfasst. Das Ladekabel zeichnet sich dadurch aus, dass zwei Messleitungen zur Spannungsmessung zu dem Übergabepunkt in dem Stecker geführt sind, damit der Stromzähler über die Messleitungen in dem Ladekabel die Spannung an dem Übergabepunkt messen kann.

In dem bevorzugten Ausführungsbeispiel der Erfindung weist das Ladekabel bezüglich des Ladestroms eine Dauerstromfestigkeit von mindestens 1A, 2A, 5A, 10A, 20A, 50A, 65A, 100A, 125A, 200A, 350A, 500A, 1250A oder 2000A auf. Hinsichtlich der Ladespannung weist das Ladekabel dagegen vorzugsweise eine Spannungsfestigkeit von mindestens 50V, 100V, 200V, 300V, 600V, 750V, 1000V oder 1500V auf.

Ferner ist zu erwähnen, dass der im Rahmen der Erfindung verwendete Begriff eines Ladekabels nicht beschränkt ist auf Ladekabel im engeren Sinne, die zum Aufladen einer wieder aufladbaren Batterie eingesetzt werden, beispielsweise zur Verbindung einer Ladesäule mit einem Elektroauto. Vielmehr ist der Begriff eines Ladekabels allgemein zu verstehen und umfasst beispielsweise auch Verbindungskabel zwischen einem Stromzähler und einem elektrischen Verbraucher.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

Figur 1 eine schematische Darstellung eines herkömmlichen Ladesystems mit einer Ladequelle, einem herkömmlichen Stromzähler, einem Ladekabel mit einem Stecker und einem Verbraucher,

Figur 2 eine schematische Darstellung des erfindungsgemäßen Stromzählers in einem Ladesystem, sowie

Figur 3 ein Flussdiagramm zur Verdeutlichung der Betriebsweise des erfindungsgemäßen Stromzählers.

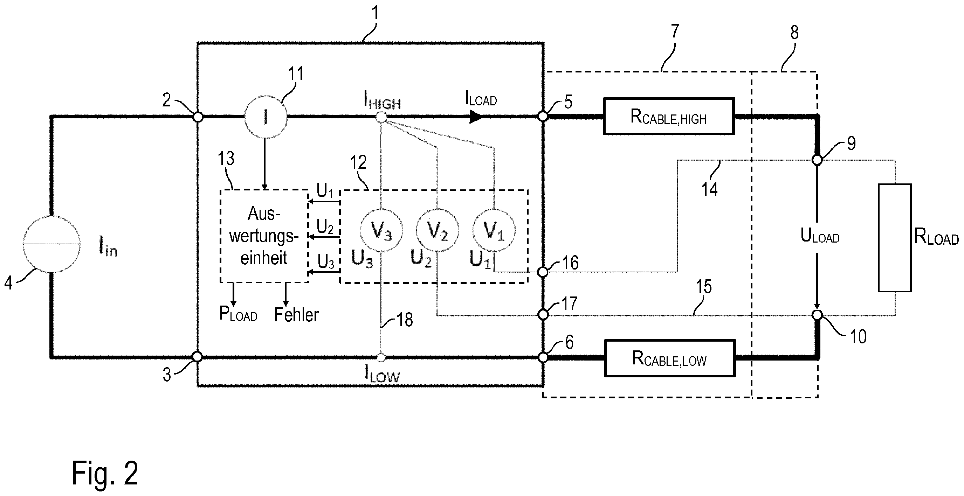

Im Folgenden wird nun das erfindungsgemäße Ausführungsbeispiel gemäß Figur 2 beschrieben, das teilweise mit dem eingangs beschriebenen und in Figur 1 gezeigten herkömmliche System übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit besteht nun darin, dass in dem Ladekabel 7 zwei Messleitungen 14, 15 verlaufen, die eine Spannungsmessung direkt an dem Übergabepunkt ermöglichen, der durch die beiden Anschlüsse 9, 10 des Steckers 8 gebildet wird. Die Messleitung 14 ermöglicht hierbei eine Spannungsmessung an der High-Side an dem Anschluss 9 des Steckers 8, während die andere Messleitung 15 eine Spannungsmessung an dem Anschluss 10 des Steckers 8 an der Low-Side ermöglicht.

Alternativ besteht jedoch auch die Möglichkeit, dass die Messleitungen 14, 15 außerhalb des Ladekabels 7 verlaufen, beispielsweise in einem separaten Messkabel.

Zur Abfrage der beiden Messleitungen 14, 15 weist der Stromzähler 1 zwei Spannungsmessanschlüsse 16, 17 auf.

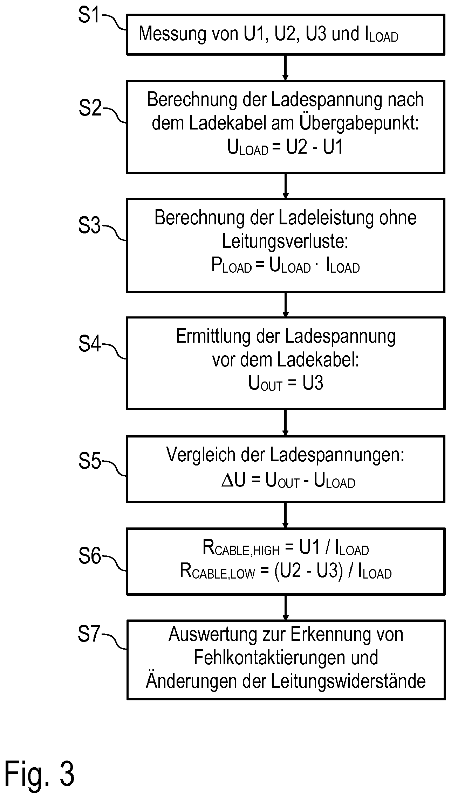

Die Spannungsmesseinrichtung 12 enthält zwei Spannungsmesser V1, V2, wobei der Spannungsmesser V1 eine Spannung U1 an dem Anschluss 9 des Steckers 8 an der High-Side misst und zwar in Bezug auf ein Referenzpotential, das durch die High-Side an dem Stromanschluss 5 gebildet wird (Schritt S1 in Fig. 3).

Darüber hinaus weist die Spannungsmesseinrichtung 12 einen Spannungsmesser V2 auf, der eine Spannung U2 an dem anderen Anschluss 10 des Steckers 8 an der Low-Side misst und zwar ebenfalls gegenüber dem Referenzpotential an dem Stromanschluss 5 an der High-Side des Stromzählers 1 (Schritt S1 in Fig. 3).

Ferner weist die Spannungsmesseinrichtung 12 einen dritten Spannungsmesser V3 auf, der über eine Messleitung 18 eine Spannung U3 zwischen High-Side und Low-Side in dem Stromzähler 1 misst (Schritt S1 in Fig. 3).

Die drei Spannungen U1, U2, U3 werden an die Auswertungseinheit 13 weiter geleitet.

Zum einen berechnet die Auswertungseinheit 13 die tatsächliche Ladespannung $U_{LOAD}$ an dem Übergabepunkt zu dem Verbraucher $R_{LOAD}$ und zwar nach folgender Formel (Schritt S2 in Fig. 3):

$$U_{LOAD} = U2 - U1$$

Zum anderen berechnet die Auswertungseinheit 13 die tatsächliche Ladeleistung $P_{LOAD}$ an dem Übergabepunkt in dem Stecker 8, der durch die beiden Anschlüsse 9, 10 des Steckers 8 gebildet wird und zwar nach folgender Formel (Schritt S3 in Fig. 3):

$$P_{LOAD} = I_{LOAD} \cdot U_{LOAD} = I_{LOAD} \cdot (U2\text{-}U1).$$

Weiterhin ermittelt die Auswertungseinheit 13 die Ladespannung $U_{OUT}$ vor dem Ladekabel 7 und zwar wie folgt (Schritt S4 in Fig. 3):

$$U_{OUT} = U3.$$

Die Auswertungseinheit 13 berechnet dann die Differenz der beiden Ladespannungen $U_{OUT}$ vor dem Ladekabel 7 und $U_{LOAD}$ hinter dem Ladekabel 7 (Schritt S5 in Fig. 3).

$$\Delta U = U_{OUT} - U_{LOAD}.$$

Die Spannungsdifferenz $\Delta U$ ermöglicht eine Erkennung, ob die Messleitungen 14, 15 angeschlossen sind.

Ferner berechnet die Auswertungseinheit 13 aber auch die Leitungswiderstände $R_{CABLE,HIGH}$, $R_{CABLE,LOW}$ in dem Ladekabel 7, wobei die Leitungswiderstände $R_{CABLE,HIGH}$, $R_{CABLE,LOW}$ auch die Kontaktierungswiderstände zwischen dem Stromzähler 1 und dem Ladekabel 7 beinhalten.

Die Berechnung der Leitungswiderstände $R_{CABLE,HIGH}$, $R_{CABLE,LOW}$ erfolgt nach folgenden Formeln (Schritt S6 in Fig. 3):

$$R_{CABLE,HIGH} = U1 / I_{LOAD}$$

$$R_{CABLE,LOW} = (U2 - U3) / I_{LOAD}$$

Die Auswertungseinheit 13 kann dann in Abhängigkeit von den berechneten Leitungswiderständen $R_{CABLE,HIGH}$, $R_{CABLE,LOW}$ und der Spannungsdifferenz $\Delta U$ ein Kontrollsignal ausgeben, das anzeigt, ob der Stecker 8 ordnungsgemäß gesteckt und eine korrekte elektrische Verbindung zu dem Verbraucher $R_{LOAD}$ herstellt.

Zum anderen kann die Auswertungseinheit 13 überprüfen, ob sich der Wert der Leitungswiderstände $R_{CABLE,HIGH}$, $R_{CABLE,LOW}$ im Betrieb langsam verändert, so dass dann ggf. ein Fehlersignal ausgegeben werden kann.

Bezugszeichenliste:

| 1 | Stromzähler |
| 2 | Eingangsseitiger High-Side-Stromanschluss |
| 3 | Eingangsseitiger Low-Side-Stromanschluss |
| 4 | Ladequelle |
| 5 | Ausgangsseitiger High-Side-Stromanschluss |
| 6 | Ausgangsseitiger Low-Side-Stromanschluss |
| 7 | Ladekabel |
| 8 | Stecker |
| 9, 10 | Anschlüsse des Steckers |
| 11 | Strommesseinrichtung |
| 12 | Spannungsmesseinrichtung |
| 13 | Auswertungseinheit |
| 14, 15 | Messleitungen im Ladekabel |
| 16, 17 | Spannungsmessanschlüsse |
| 18 | Messleitung im Stromzähler |
| $I_{Load}$ | Ladestrom |
| $I_{in}$ | Eingangsstrom von der Ladequelle |
| $P_{LOAD}$ | Ladeleistung |
| $R_{CABLE,HIGH}$ | Leitungswiderstand im Ladekabel auf der High-Side |
| $R_{CABLE,LOW}$ | Leitungswiderstand im Ladekabel auf der Low-Side |
| $R_{LOAD}$ | Verbraucher |
| U1, U2, U3 | Spannungsmesswerte |
| $U_{LOAD}$ | Ladespannung am Übergabepunkt |
| $U_{OUT}$ | Ausgangsspannung am Stromzähler vor dem Ladekabel |
| V1, V2, V3 | Spannungsmesser |

**Patentansprüche**

1. Ladesystem zum Aufladen eines Verbrauchers ($R_{LOAD}$), insbesondere eines Elektroautos, mit

    a) einem Ladekabel (7) mit

        a1) einem Stecker (8) ausgebildet zur lösbaren Verbindung einer Ladequelle (4) mit dem Verbraucher ($R_{LOAD}$) und zur Bildung eines Übergabepunkts (9, 10) zu dem Verbraucher ($R_{LOAD}$),
        a2) einer ersten Ladeleitung ($R_{CABLE,HIGH}$) ausgebildet zur Hinführung eines Ladestroms ($I_{LOAD}$) zu dem Verbraucher ($R_{LOAD}$),
        a3) einer zweiten Ladeleitung ($R_{CABLE,LOW}$) ausgebildet zur Rückführung des Ladestroms ($I_{LOAD}$) von dem Verbraucher ($R_{LOAD}$), und

    b) einem Stromzähler (1) ausgebildet zur elektrischen Verbrauchsmessung an dem elektrischen Verbraucher ($R_{LOAD}$), mit

        b1) einer Strommesseinrichtung (11) ausgebildet zur Messung des Ladestroms ($I_{LOAD}$), der über das Ladekabel (7) zu dem Übergabepunkt (9, 10) für den Verbraucher

($R_{LOAD}$) fließt, wobei sich der Übergabepunkt (9, 10) in dem Stecker (8) des Ladekabels (7) befindet, und

b2) einer Spannungsmesseinrichtung (12) ausgebildet zur Spannungsmessung,

**dadurch gekennzeichnet,**

c) **dass** die Spannungsmesseinrichtung (12) ebenfalls ausgebildet ist, um die Spannung direkt an dem Übergabepunkt (9, 10) des Ladekabels (7) zu messen, um Leitungsverluste in dem Ladekabel (7) zu ermitteln, insbesondere zur Berücksichtigung der Leitungsverluste bei der Verbrauchsberechnung, und

d) **dass** das Ladekabel (7) folgendes aufweist:

d1) eine erste Messleitung (14) ausgebildet zur Messung der Ladespannung direkt an dem Übergabepunkt (9) in dem Stecker (8), wobei die erste Messleitung (14) von dem Übergabepunkt (9) ausgeht und entlang dem Ladekabel (7) zu dem Stromzähler (1) geführt ist, und

d2) eine zweite Messleitung (15) ausgebildet zur Messung der Ladespannung direkt an dem Übergabepunkt (10) in dem Stecker (8), wobei die zweite Messleitung (15) von dem Übergabepunkt (10) ausgeht und entlang dem Ladekabel (7) zu dem Stromzähler (1) geführt ist.

2. Ladesystem nach Anspruch 1, **gekennzeichnet durch**

a) einen eingangsseitigen ersten Stromanschluss (2) zur Aufnahme des Ladestroms ($I_{LOAD}$) von einer Ladequelle (4),

b) einen eingangsseitigen zweiten Stromanschluss (3) zur Rückführung des Ladestroms ($I_{LOAD}$) zu der Ladequelle (4),

c) einen ausgangsseitigen ersten Stromanschluss (5) zur Hinführung des Ladestroms ($I_{LOAD}$) über das Ladekabel (7) zu dem Übergabepunkt (9, 10) an dem Verbraucher ($R_{LOAD}$), und

d) einen ausgangsseitigen zweiten Stromanschluss (6) zur Rückführung des Ladestroms ($I_{LOAD}$) von dem Verbraucher ($R_{LOAD}$) über das Ladekabel (7).

3. Ladesystem nach Anspruch 2, **dadurch gekennzeichnet,**

a) **dass** die Spannungsmesseinrichtung (12) einen ersten Spannungsmesseingang (16) aufweist zur Messung einer ersten Spannung (U1) direkt an dem Übergabepunkt (9) zu dem Verbraucher ($R_{LOAD}$) gegenüber einem Referenzpotential, und/oder

b) **dass** die Spannungsmesseinrichtung (12) einen zweiten Spannungsmesseingang (17) aufweist zur Messung einer zweiten Spannung (U2) direkt an dem Übergabepunkt (10) zu dem Verbraucher ($R_{LOAD}$) gegenüber dem Referenzpotential, und/oder

c) **dass** die Spannungsmesseinrichtung einen dritten Spannungsmesseingang (18) aufweist zur Messung einer dritten Spannung (U3) an dem eingangsseitigen zweiten Stromanschluss (6) gegenüber dem Referenzpotential.

4. Ladesystem nach Anspruch 3, **dadurch gekennzeichnet,**

a) **dass** der erste Spannungsmesseingang (16) über einen ersten Spannungsteiler mit dem Referenzpotential verbunden ist, und/oder

b) **dass** der zweite Spannungsmesseingang (17) über einen zweiten Spannungsteiler mit dem Referenzpotential verbunden ist, und/oder

c) **dass** der eingangsseitige dritte Spannungsmesseingang (18) über einen dritten Spannungsteiler mit dem Referenzpotential verbunden ist.

5. Ladesystem nach Anspruch 4, **dadurch gekennzeichnet, dass** das Referenzpotential durch den ausgangsseitigen ersten Stromanschluss (5) gebildet wird.

6. Ladesystem nach einem der vorhergehenden Ansprüche, **gekennzeichnet durch** eine Auswertungseinheit (13) zur Ermittlung der in dem Ladekabel (7) auftretenden Leitungsverluste in Abhängigkeit von der Spannungsmessung durch die Spannungsmesseinrichtung (12).

7. Ladesystem nach Anspruch 6, **dadurch gekennzeichnet,**

a) **dass** die Auswertungseinheit (13) die direkt an dem Übergabepunkt (9, 10) abfallende Ladespannung aus der ersten Spannung (U1) und der zweiten Spannung (U2) berechnet, und/oder

b) **dass** die Auswertungseinheit (13) den Spannungsabfall über einer ersten Ladeleitung des Ladekabels (7) aus der zweiten Spannung (U2) gegenüber dem Referenzpotential berechnet, und/oder

c) **dass** die Auswertungseinheit (13) den Spannungsabfall über einer zweiten Ladeleitung des Ladekabels (7) aus der dritten Spannung (U3) und der ersten Spannung (U1) berechnet, und/oder

d) **dass** die Auswertungseinheit (13) die Leitungsverluste in dem Ladekabel (7) aus folgenden Messwerten berechnet:

d1) der ersten Spannung (U1)
d2) der zweiten Spannung (U2),
d3) der dritten Spannung (U3), und
d4) dem Ladestrom ($I_{LOAD}$), und/oder

e) **dass** die Auswertungseinheit (13) den Leitungswiderstand ($R_{CABLE,HIGH}$) der ersten Ladeleitung des Ladekabels (7) in Abhängigkeit von dem Ladestrom ($I_{LOAD}$) und der ersten Spannung (U1) berechnet, und/oder

f) **dass** die Auswertungseinheit (13) den Leitungswiderstand der zweiten Ladeleitung ($R_{CABLE,LOW}$) des Ladekabels (7) in Abhängigkeit von dem Ladestrom ($I_{LOAD}$) und der ersten Spannung (U1) und der zweiten Spannung (U2) berechnet.

8. Ladesystem nach Anspruch 7, **dadurch gekennzeichnet,**

a) **dass** die Auswertungseinheit (13) einen ersten Messwert der Ladespannung ($U_{OUT}$) berechnet aus dem Referenzpotential und der dritten Spannung (U3), wobei der erste Messwert ($U_{OUT}$) keine Leitungsverluste in dem Ladekabel (7) berücksichtigt, und

b) **dass** die Auswertungseinheit einen zweiten Messwert der Ladespannung ($U_{LOAD}$) berechnet aus der ersten Spannung (U1) an dem Übergabepunkt (9, 10) und der zweiten Spannung (U2) an dem Übergabepunkt (9, 10), wobei der zweite Messwert ($U_{LOAD}$) die Leitungsverluste in dem Ladekabel (7) berücksichtigt.

c) **dass** die Auswertungseinheit (13) die beiden Messwerte ($U_{OUT}$, $U_{LOAD}$) der Ladespannung miteinander vergleicht und in Abhängigkeit von dem Vergleich ein Fehlersignal ausgibt, insbesondere zur Signalisierung eines Leitungsbruchs in dem Ladekabel (7) oder einer schlechten Kontaktqualität zwischen dem Stromzähler (1) und dem Übergabepunkt (9, 10).

9. Ladesystem nach einem der vorhergehenden Ansprüche, **dadurch gekennzeichnet,**

a) **dass** der eingangsseitige zweite Stromanschluss (3) leitend mit dem ausgangsseitigen zweiten Stromanschluss (6) verbunden oder in einem einzigen Stromanschluss zusammengefasst ist, und/oder

b) **dass** der eingangsseitige erste Stromanschluss (2) über den niederohmigen Strommesswiderstand mit dem ausgangsseitigen ersten Stromanschluss (5) verbunden ist.

10. Ladesystem nach einem der vorhergehenden Ansprüche, **dadurch gekennzeichnet,**

a) **dass** der Stromzähler (1) ein Gleichstromzähler ist,

b) **dass** der eingangsseitige erste Stromanschluss (2) ein High-Side-Stromanschluss (2) ist, der den Ladestrom ($I_{LOAD}$) an der High-Side von der Ladequelle (4) aufnimmt,

c) **dass** der eingangsseitige zweite Stromanschluss (3) ein Low-Side-Stromanschluss (3) ist, der den Ladestrom ($I_{LOAD}$) an der Low-Side zu der Ladequelle (4) zurückführt,

d) **dass** der ausgangsseitige erste Stromanschluss (5) ein High-Side-Stromanschluss (5) ist, der den Ladestrom ($I_{LOAD}$) an der High-Side zu dem Verbraucher ($R_{LOAD}$) ausgibt,

e) **dass** der ausgangsseitige zweite Stromanschluss (6) ein Low-Side-Stromanschluss (6) ist, der den Ladestrom ($I_{LOAD}$) an der Low-Side vom Verbraucher ($R_{LOAD}$) aufnimmt,

f) **dass** der erste Spannungsmesseingang (16) ein High-Side-Spannungsmesseingang (16) ist,

g) **dass** der zweite Spannungsmesseingang (17) ein Low-Side-Spannungsmesseingang (17) ist,

h) **dass** die erste Ladeleitung des Ladekabels (7) ein High-Side-Leitung ist, und

i) **dass** die zweite Ladeleitung des Ladekabels (7) eine Low-Side-Leitung ist.

11. Ladesystem nach einem der vorhergehenden Ansprüche, **dadurch gekennzeichnet,**

a) **dass** das Ladekabel (7) bezüglich des Ladestroms ($I_{LOAD}$) eine Dauerstromfestigkeit von mindestens 1A, 2A, 5A, 10A, 20A, 50A oder 100A aufweist, Und/oder

b) **dass** das Ladekabel (7) bezüglich der Ladespannung eine Spannungsfestigkeit von mindestens 50V, 100V, 200V oder 300V aufweist, und/oder

c) **dass** die erste Ladeleitung ($R_{CABLE,HIGH}$) des Ladekabels (7) ein High-Side-Leitung ist, und/oder

d) **dass** die zweite Ladeleitung ($R_{CABLE,LOW}$) des Ladekabels (7) eine Low-Side-Leitung ist.

12. Ladesystem nach einem der vorhergehenden Ansprüche, **gekennzeichnet durch** die Ladequelle (4) zur Lieferung des Ladestroms ($I_{LOAD}$) zum Aufladen des Verbrauchers ($R_{LOAD}$), wobei der Stromzähler (1) einerseits mit der Ladequelle (4) und andererseits mit dem Ladekabel (7) verbunden ist.

**Claims**

1. Charging system for charging a load ($R_{LOAD}$), in particular an electric car, with

    a) a charging cable (7) with

        a1) a plug (8) adapted for detachably connecting a charging source (4) to a load ($R_{LOAD}$) and for forming a transfer point (9, 10) to the load ($R_{LOAD}$),
        a2) a first charging line ($R_{CABLE,HIGH}$) adapted for conducting a charging current ($I_{LOAD}$) to the load ($R_{LOAD}$),
        a3) a second charging line ($R_{CABLE,LOW}$) adapted to return the charging current ($I_{LOAD}$) from the load ($R_{LOAD}$), and

    b) an electric meter (1) adapted for electrical consumption measurement at the electrical load ($R_{LOAD}$), with

        b1) a current measuring device (11) adapted for measuring a charging current ($I_{LOAD}$) which flows via the charging cable (7) to the transfer point (9, 10) for the load ($R_{LOAD}$), the transfer point (9, 10) being located in the plug (8) of the charging cable (7), and
        b2) a voltage measuring device (12) adapted for voltage measurement,

    **characterized in**
    c) **that** the voltage measuring device (12) is also adapted to measure the voltage directly at the transfer point (9, 10) of the charging cable (7) in order to determine line losses in the charging cable (7), in particular to take the line losses into account when calculating the consumption, and
    d) **that** the charging cable (7) comprises the following:

        d1) a first measuring line (14) adapted for measuring the charging voltage directly at the transfer point (9, 10) in the plug (8), the first measuring line extending along the charging cable (7) to the transfer point (9, 10) in the plug (8),
        d2) a second measuring line (15) adapted for measuring the charging voltage directly at the transfer point (9, 10) in the plug (8), the second measuring line (15) extending along the charging cable (7) to the transfer point (9, 10) in the plug (8).

2. Charging system according to claim 1, **characterized by**

    a) a first current connection (2) on the input side for receiving the charging current ($I_{LOAD}$) from a charging source (4),
    b) a second current connection (3) on the input side to return the charging current ($I_{LOAD}$) to the charging source (4),
    c) a first current connection (5) on the output side for conducting the charging current ($I_{LOAD}$) via the charging cable (7) to the transfer point (9, 10) at the load ($R_{LOAD}$), and
    d) a second current connection (6) on the output side to return the charging current ($I_{LOAD}$) from the load ($R_{LOAD}$) via the charging cable (7).

3. Charging system according to claim 2, **characterized in**

    a) **that** the voltage measuring device (12) has a first voltage measuring input (16) for measuring a first voltage (U1) directly at the transfer point (9) to the load ($R_{LOAD}$) with respect to a reference potential, and/or
    b) **that** the voltage measuring device (12) has a second voltage measuring input (17) for measuring a second voltage (U2) directly at the transfer point (10) to the load ($R_{LOAD}$) with respect to the reference potential, and/or
    c) **that** the voltage measuring device has a third voltage measuring input (18) for measuring a third voltage (U3) at the input-side second current connection (6) relative to the reference potential.

4. Charging system according to claim 3, **characterized in**

    a) **that** the first voltage measuring input (16) is connected to the reference potential via a first voltage divider, and/or
    b) **that** the second voltage measuring input (17) is connected to the reference potential via a second voltage divider, and/or
    c) **that** the third voltage measuring input (18) on the input side is connected to the reference potential via a third voltage divider.

5. Charging system according to claim 4, **characterized in that** the reference potential is formed by the output-side first current connection (5).

6. Charging system according to one of the preceding claims, **characterized by** an evaluation unit (13) for determining the line losses occurring in the charging cable (7) in dependence on the voltage measurement by the voltage measuring device (12).

7. Charging system according to claim 6, **characterized in**

a) **that** the evaluation unit (13) calculates the charging voltage dropping directly at the transfer point (9, 10) from the first voltage (U1) and the second voltage (U2), and/or

b) **that** the evaluation unit (13) calculates the voltage drop across a first charging line of the charging cable (7) from the second voltage (U2) relative to the reference potential, and/or

c) **that** the evaluation unit (13) calculates the voltage drop across a second charging line of the charging cable (7) from the third voltage (U3) and the first voltage (U1), and/or

d) **that** the evaluation unit (13) calculates the line losses in the charging cable (7) from the following measured values:

d1) the first voltage (U1)
d2) the second voltage (U2),
d3) the third voltage (U3), and
d4) the charging current ($I_{LOAD}$), and/or

e) **that** the evaluation unit (13) calculates the line resistance ($R_{CABLE,HIGH}$) of the first charging line of the charging cable (7) as a function of the charging current ($I_{LOAD}$) and the first voltage (U1), and/or

f) **that** the evaluation unit (13) calculates the line resistance of the second charging line ($R_{CAB-LE,LOW}$) of the charging cable (7) as a function of the charging current ($I_{LOAD}$) and the first voltage (U1) and the second voltage (U2).

8. Charging system according to claim 7, **characterized in**

a) **that** the evaluation unit (13) calculates a first measured value of the charging voltage ($U_{OUT}$) from the reference potential and the third voltage (U3), the first measured value ($U_{OUT}$) not taking into account any line losses in the charging cable (7), and

b) **that** the evaluation unit calculates a second measured value of the charging voltage ($U_{LOAD}$) from the first voltage (U1) at the transfer point (9, 10) and the second voltage (U2) at the transfer point (9, 10), the second measured value ($U_{LOAD}$) taking into account the line losses in the charging cable (7),

c) **that** the evaluation unit (13) compares the two measured values ($U_{OUT}$, $U_{LOAD}$) of the charging voltage with one another and, depending on the comparison, outputs an error signal, in particular to signal a line break in the charging cable (7) or a poor contact quality between the electric meter (1) and the transfer point (9, 10).

9. Charging system according to one of the preceding claims, **characterized in**

a) **that** the second current connection (3) on the input side is conductively connected to the second current connection (6) on the output side or is combined in a single current connection, and/or

b) **that** the first current connection (2) on the input side is connected to the first current connection (5) on the output side via the low-impedance current measuring resistor.

10. Charging system according to one of the preceding claims, **characterized in**

a) **that** the electric meter (1) is a direct current meter,

b) **that** the first current connection (2) on the input side is a high-side current connection (2) which receives the charging current ($I_{LOAD}$) at the high-side from the charging source (4),

c) **that** the second current connection (3) on the input side is a low-side current connection (3) which returns the charging current ($I_{LOAD}$) at the low-side to the charging source (4),

d) **that** the output-side first current connection (5) is a high-side current connection (5) which outputs the charging current ($I_{LOAD}$) at the high-side to the load ($R_{LOAD}$),

e) **that** the output-side second current connection (6) is a low-side current connection (6) which takes up the charging current ($I_{LOAD}$) at the low-side from the load ($R_{LOAD}$),

f) **that** the first voltage measuring input (16) is a high-side voltage measuring input (16),

g) **that** the second voltage measuring input (17) is a low-side voltage measuring input (17),

h) **that** the first charging line of the charging cable (7) is a high-side line, and

i) **that** the second charging line of the charging cable (7) is a low-side line.

11. Charging system according to any of the preceding claims, **characterized in**

a) **that** the charging cable (7) has a continuous current-carrying capacity with respect to the charging current ($I_{LOAD}$) of at least 1A, 2A, 5A, 10A, 20A, 50A or 100A, and/or

b) **that** the charging cable (7) has a proof voltage of at least 50V, 100V, 200V or 300V with respect to the charging voltage, and/or

c) **that** the first charging line ($R_{CABLE,HIGH}$) of the charging cable (7) is a high-side line, and/or

d) **that** the second charging line ($R_{CABLE,LOW}$) of the charging cable (7) is a low-side line.

12. Charging system according to any of the preceding claims **characterized by** the charging source (4) for supplying the charging current ($I_{LOAD}$) for charging the load ($R_{LOAD}$), wherein the electric meter (1) is connected to the charging source (4) on the one hand and to the charging cable (7) on the other hand.

**Revendications**

1. Système de charge pour la charge d'un consommateur ($R_{LOAD}$), en particulier d'une voiture électrique, avec

    a) un câble de charge (7) avec

        a1) un connecteur (8) réalisé pour la liaison amovible d'une source de charge (4) avec le consommateur ($R_{LOAD}$) et pour la formation d'un point de remise (9, 10) au consommateur ($R_{LOAD}$),
        a2) une première conduite de charge ($R_{CABLE,HIGH}$) réalisé pour le passage d'un courant de charge ($I_{LOAD}$) au consommateur ($R_{LOAD}$),
        a3) une seconde conduite de charge ($R_{CABLE,LOW}$) réalisé pour le retour du courant de charge ($I_{LOAD}$) du consommateur ($R_{LOAD}$), et

    b) un compteur de courant (1) réalisé pour la mesure de la consommation électrique au niveau du consommateur électrique ($R_{LOAD}$), avec

        b1) un dispositif de mesure de courant (11) réalisé pour la mesure du courant de charge ($I_{LOAD}$) qui circule par le biais du câble de charge (7) au point de remise (9, 10) pour le consommateur ($R_{LOAD}$), dans lequel le point de remise (9, 10) se situe dans le connecteur (8) du câble de charge (7), et
        b2) un dispositif de mesure de tension (12) réalisé pour la mesure de tension,

    **caractérisé en ce que**
    c) le dispositif de mesure de tension (12) est aussi réalisé afin de mesurer la tension directement au point de remise (9, 10) du câble de charge (7) afin de déterminer des pertes de conduite dans le câble de charge (7), en particulier pour tenir compte des pertes de conduite lors du calcul de la consommation, et
    d) le câble de charge (7) présente ce qui suit :

        d1) une première conduite de mesure (14) réalisée pour la mesure de la tension de charge directement au point de remise (9) dans le connecteur (8), dans lequel la première conduite de mesure (14) sort du point de remise (9) et est guidée le long du câble de charge (7) au compteur électrique (1), et
        d2) une seconde conduite de mesure (15) réalisée pour la mesure de la tension de charge directement au point de remise (10) dans le connecteur (8), dans lequel la seconde conduite de mesure (15) sort du point de remise (10) et est guidée le long du câble de charge (7) au compteur électrique (1).

2. Système de charge selon la revendication 1, **caractérisé par**

    a) un premier raccord de courant (2) côté entrée pour la réception du courant de charge ($I_{LOAD}$) d'une source de charge (4),
    b) un second raccord de courant (3) côté entrée pour le retour du courant de charge ($I_{LOAD}$) à la source de charge (4),
    c) un premier raccord de courant (5) côté sortie pour le passage du courant de charge ($I_{LOAD}$) par le biais du câble de charge (7) au point de remise (9, 10) au niveau du consommateur ($R_{LOAD}$), et
    d) un second raccord de courant (6) côté sortie pour le retour du courant de charge ($I_{LOAD}$) du consommateur ($R_{LOAD}$) par le biais du câble de charge (7).

3. Système de charge selon la revendication 2, **caractérisé en ce que**

    a) le dispositif de mesure de tension (12) présente une première entrée de mesure de tension (16) pour la mesure d'une première tension (U1) directement au point de remise (9) au consommateur ($R_{LOAD}$) par rapport à un potentiel de référence, et/ou
    b) le dispositif de mesure de tension (12) présente une deuxième entrée de mesure de tension (17) pour la mesure d'une deuxième tension (U2) directement au point de remise (10) au consommateur ($R_{LOAD}$) par rapport au potentiel de référence, et/ou
    c) le dispositif de mesure de tension présente une troisième entrée de mesure de tension (18) pour la mesure d'une troisième tension (U3) sur le second raccord de courant (6) côté entrée par rapport au potentiel de référence.

4. Système de charge selon la revendication 3, **caractérisé en ce que**

    a) la première entrée de mesure de tension (16) est reliée par le biais d'un premier diviseur de tension au potentiel de référence, et/ou
    b) la deuxième entrée de mesure de tension (17) est reliée par le biais d'un deuxième diviseur de tension au potentiel de référence, et/ou

c) la troisième entrée de mesure de tension (18) côté entrée est reliée par le biais d'un troisième diviseur de tension au potentiel de référence.

5. Système de charge selon la revendication 4, **caractérisé en ce que** le potentiel de référence est formé par le premier raccord de courant (5) côté sortie.

6. Système de charge selon l'une des revendications précédentes, **caractérisé par** une unité d'évaluation (13) pour la détermination des pertes de conduite survenant dans le câble de charge (7) en fonction de la mesure de tension par le dispositif de mesure de tension (12).

7. Système de charge selon la revendication 6, **caractérisé en ce que**

    a) l'unité d'évaluation (13) calcule la tension de charge diminuant directement au point de remise (9, 10) à partir de la première tension (U1) et de la deuxième tension (U2), et/ou
    b) l'unité d'évaluation (13) calcule la chute de tension par le biais d'une première conduite de charge du câble de charge (7) à partir de la deuxième tension (U2) par rapport au potentiel de référence, et/ou
    c) l'unité d'évaluation (13) calcule la chute de tension par le biais d'une seconde conduite de charge du câble de charge (7) à partir de la troisième tension (U3) et de la première tension (U1), et/ou
    d) l'unité d'évaluation (13) calcule les pertes de conduite dans le câble de charge (7) à partir des valeurs de mesure suivantes :

        d1) la première tension (U1),
        d2) la deuxième tension (U2),
        d3) la troisième tension (U3), et
        d4) le courant de charge ($I_{LOAD}$), et/ou

    e) l'unité d'évaluation (13) calcule la résistance de conduite ($R_{CABLE,HIGH}$) de la première conduite de charge du câble de charge (7) en fonction du courant de charge ($I_{LOAD}$) et de la première tension (U1), et/ou
    f) l'unité d'évaluation (13) calcule la résistance de conduite de la seconde conduite de charge ($R_{CABLE,LOW}$) du câble de charge (7) en fonction du courant de charge ($I_{LOAD}$) et de la première tension (U1) et de la deuxième tension (U2).

8. Système de charge selon la revendication 7, **caractérisé en ce que**

    a) l'unité d'évaluation (13) calcule une première valeur de mesure de la tension de charge ($U_{OUT}$) à partir du potentiel de référence et de la troisième tension (U3), dans lequel la première valeur de mesure ($U_{OUT}$) ne tient compte d'aucune perte de conduite dans le câble de charge (7), et
    b) l'unité d'évaluation calcule une seconde valeur de mesure de la tension de charge ($U_{LOAD}$) à partir de la première tension (U1) au point de remise (9, 10) et de la deuxième tension (U2) au point de remise (9, 10), dans lequel la seconde valeur de mesure ($U_{LOAD}$) tient comte des pertes de conduite dans le câble de charge (7),
    c) l'unité d'évaluation (13) compare les deux valeurs de mesure ($U_{OUT}$,$U_{LOAD}$) de la tension de charge l'une à l'autre et en fonction de la comparaison émet un signal d'erreur, en particulier pour la signalisation d'une rupture de conduite dans le câble de charge (7) ou une mauvaise qualité de contact entre le compteur de courant (1) et le point de remise (9, 10) .

9. Système de charge selon l'une des revendications précédentes, **caractérisé en ce que**

    a) le second raccord de courant (3) côté entrée est relié de manière conductrice au second raccord de courant (6) côté sortie ou est compris dans un seul raccord de courant, et/ou
    b) le premier raccord de courant (2) côté entrée est relié par le biais de la résistance de mesure de courant de basse impédance au premier raccord de courant (5) côté sortie.

10. Système de charge selon l'une des revendications précédentes, **caractérisé en ce que**

    a) le compteur électrique (1) est un compteur à courant continu,
    b) le premier raccord de courant (2) côté entrée est un raccord de courant High-Side (2) qui reçoit le courant de charge ($I_{LOAD}$) sur le High-Side de la source de charge (4),
    c) le second raccord de courant (3) côté entrée est un raccord de courant Low-Side (3) qui ramène le courant de charge ($I_{LOAD}$) sur le Low-Side à la source de charge (4),
    d) le premier raccord de courant (5) côté sortie est un raccord de courant High-Side (5) qui fournit le courant de charge ($I_{LOAD}$) sur le High-Side au consommateur ($R_{LOAD}$),
    e) le second raccord de courant (6) côté sortie est un raccord de courant Low-Side (6) qui reçoit le courant de charge ($I_{LOAD}$) sur le Low-Side du consommateur ($R_{LOAD}$),
    f) la première entrée de mesure de tension (16) est une entrée de mesure de tension High-Side (16),
    g) la seconde entrée de mesure de tension (16) est une entrée de mesure de tension Low-Side (17),

h) la première conduite de charge du câble de charge (7) est une conduite High-Side, et
i) la seconde conduite de charge du câble de charge (7) est une conduite Low-Side.

11. Système de charge selon l'une des revendications précédentes, **caractérisé en ce que**

a) le câble de charge (7) présente par rapport au courant de charge ($I_{LOAD}$) une résistance au courant permanent d'au moins 1A, 2A, 5A, 10A, 20A, 50A ou 100A, et/ou
b) le câble de charge (7) présente par rapport à la tension de charge une résistance à la tension d'au moins 50 V, 100 V, 200 V ou 300 V, et/ou
c) la première conduite de câble ($R_{CABLE,HIGH}$) du câble de charge (7) est une conduite High-Side, et/ou
d) la seconde conduite de charge ($R_{CABLE,LOW}$) du câble de charge (7) est une conduite Low-Side.

12. Système de charge selon l'une des revendications précédentes, **caractérisé par** la source de charge (4) pour la livraison du courant de charge ($I_{LOAD}$) pour la charge du consommateur ($R_{LOAD}$), dans lequel le compteur de charge (1) est relié d'une part à la source de charge (4) et d'autre part au câble de charge (7).

Fig. 1

Fig. 2

EP 3 867 653 B1

S1 — Messung von U1, U2, U3 und $I_{LOAD}$

S2 — Berechnung der Ladespannung nach dem Ladekabel am Übergabepunkt:
$U_{LOAD} = U2 - U1$

S3 — Berechnung der Ladeleistung ohne Leitungsverluste:
$P_{LOAD} = U_{LOAD} \cdot I_{LOAD}$

S4 — Ermittlung der Ladespannung vor dem Ladekabel:
$U_{OUT} = U3$

S5 — Vergleich der Ladespannungen:
$\Delta U = U_{OUT} - U_{LOAD}$

S6 — $R_{CABLE,HIGH} = U1 / I_{LOAD}$
$R_{CABLE,LOW} = (U2 - U3) / I_{LOAD}$

S7 — Auswertung zur Erkennung von Fehlkontaktierungen und Änderungen der Leitungswiderstände

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011285350 A1
- FR 2947055 A1
- KR 20160096350 A
- FR 2987449 A
- US 2015346288 A1
- EP 0787994 A1
- CN 104682520 A
- KR 20160051363 A
- CN 205185893 U
- CN 105699816 A
- JP 2001028844 A
- US 2010174667 A1

**In der Beschreibung aufgeführte Nicht-Patentliteratur**

- **WINKLER T. et al.** Electric vehicle charging stations in Magdeburg. VPPC, 2009, 60-65